# EUROPEAN PATENT APPLICATION

(11) **EP 4 831 652 A1**
(43) Date of publication of application: **28.10.2026**
(21) Application number: 24919841.7
(22) Date of filing: 01.11.2024
(51) Int. Cl.: G01R 15/24

(54) **METHOD AND APPARATUS FOR DETERMINING CURRENT ON BASIS OF OPTICAL CURRENT TRANSFORMER**

(30) Priority: 22.01.2024 CN 202410088941
(71) Applicant: Siemens Aktiengesellschaft, 80333 München (DE)
(72) Inventor: CAO, Qi, Nanjng, Jiangsu 211200 (CN); ZHAO, Shu Yao, Nanjng, Jiangsu 211200 (CN); SUN, Xuan, Nanjng, Jiangsu 211200 (CN)
(74) Representative: HKW Intellectual Property PartG mbB
(86) International application number: PCT/CN2024/129434
(87) International publication number: WO 2025/156761

(57) **Abstract**

A method and an apparatus for determining a current based on an optical current transformer are provided. The method includes: obtaining, according to a preset sampling period, first emergent light intensity sampling values generated by a first optical current transformer; obtaining, according to the preset sampling period, second emergent light intensity sampling values generated by a second optical current transformer; identifying whether each of the first emergent light intensity sampling values exceeds a first light intensity measurement range; determining, when a first emergent light intensity sampling value falls within the first light intensity measurement range, a first final real-time current value of a target device at the same sampling time based on the first emergent light intensity sampling value and a second emergent light intensity sampling value at the same sampling time; and generating a current waveform of the target device based on the first final real-time current value, and performing a relay protection operation based on the current waveform.

## Description

### TECHNICAL FIELD

The present invention relates to the field of power systems, and in particular, to a method and an apparatus for determining a current based on an optical current transformer.

### BACKGROUND

For an optical current transformer (Optical Current Transformer, OCT), an operating principle is to calculate a current of a measured device using the Faraday magneto-optical effect. Specifically, in a magneto-optical material, an externally applied magnetic field may cause a corresponding rotation of the plane of linearly polarized light propagating along the direction of the magnetic field. A deflection angle of incident light is related to the magnetic field strength (corresponding to a magnitude of the current), an interaction length between the light and the magnetic field in a transparent material, and properties of the material. Therefore, a corresponding magnitude of a primary-side current can be calculated by measuring the deflection angle.

Therefore, how to accurately determine the magnitude of a primary-side current has become a problem that urgently needs to be resolved.

### SUMMARY

In view of this, the present invention provides a method for determining a current based on an optical current transformer, where a target device corresponds to both a first optical current transformer and a second optical current transformer, and the target device operates on alternating current, where the first optical current transformer and the second optical current transformer are both configured to determine a real-time current value of the target device, a real-time current of the target device is directly proportional to an emergent light intensity of the first optical current transformer, the real-time current of the target device is directly proportional to an emergent light intensity of the second optical current transformer, the first optical current transformer corresponds to a first light intensity measurement range, and the second optical current transformer corresponds to a second light intensity measurement range, the second light intensity measurement range being greater than the first light intensity measurement range.

The method includes:
obtaining, according to a preset sampling period, first emergent light intensity sampling values generated by the first optical current transformers;
obtaining, according to the preset sampling period, second emergent light intensity sampling values generated by the second optical current transformer;
identifying whether each of the first emergent light intensity sampling values exceeds the first light intensity measurement range;
determining, when a first emergent light intensity sampling value falls within the first light intensity measurement range, a first final real-time current value of the target device at the same sampling time based on the first emergent light intensity sampling value and a second emergent light intensity sampling value at the same sampling time; and
generating a current waveform of the target device based on the first final real-time current value, and performing a relay protection operation based on the current waveform.

According to the foregoing method, optionally, the method further includes:
using, if an identification result is that the second emergent light intensity sampling value exceeds the second light intensity measurement range, a last second emergent light intensity sampling value that does not exceed the second light intensity measurement range as a first final light intensity of the target device within a first time period, and determining, based on the first final light intensity, a second final real-time current value of the target device within the first time period, where all second emergent light intensity sampling values within the first time period exceed the second light intensity measurement range; and
generating a current waveform of the target device based on the second final real-time current value.

According to the foregoing method, optionally, the method further includes:
determining, if it is identified that the first emergent light intensity sampling value exceeds the first light intensity measurement range, a fourth final real-time current value of the target device based on the second emergent light intensity sampling value when it is determined that the second emergent light intensity sampling value falls within the second light intensity measurement range.

According to the foregoing method, optionally, determining a first final real-time current of the target device at the same sampling time based on the first emergent light intensity sampling value and the second emergent light intensity sampling value at the same sampling time includes:
determining a first current value based on the first emergent light intensity sampling value at the same sampling time;
determining a second current value based on the second emergent light intensity sampling value at the same sampling time; and
determining the first final real-time current of the target device at the same sampling time according to the following formula: first final real-time current = first current value * preset weight value + second current value * (1 - preset weight value).

According to the foregoing method, optionally, the preset weight value q satisfies 0.7 ≤ q ≤ 0.9.

According to the foregoing method, optionally, the first optical current transformer corresponds to a first maximum light intensity measurement value and a first minimum light intensity measurement value, and the second optical current transformer corresponds to a second maximum light intensity measurement value and a second minimum light intensity measurement value, where the second maximum measurement value is greater than the first maximum measurement value, and the second minimum measurement value is less than the first minimum measurement value; $the first maximum measurement value = \frac{1}{{COS}^{2} {φ}_{0}} ∗ {I}_{1} ∗ {k}_{1 u} ;$ $the first minimum measurement value = \frac{1}{{COS}^{2} {φ}_{0}} ∗ {I}_{1} ∗ {k}_{1 d} ;$ $the second maximum measurement value = \frac{1}{{COS}^{2} {φ}_{0}} ∗ {I}_{2} ∗ {k}_{2 u} ;$ $the second minimum measurement value = \frac{1}{{COS}^{2} {φ}_{0}} ∗ {I}_{2} ∗ {k}_{2 d} ;$ ${k}_{1 u} = preset factor * \left(1-\frac{{γ}_{1}}{{φ}_{0}}\right) ;$ ${k}_{1 d} = \left(1-preset factor\right) * \left(1-\frac{{γ}_{1}}{{φ}_{0}}\right) ;$ ${k}_{2 u} = preset factor * \left(1-\frac{{γ}_{2}}{{φ}_{0}}\right) ;$ and ${k}_{2 d} = \left(1-preset factor\right) * \left(1-\frac{{γ}_{2}}{{φ}_{0}}\right) ,$ where
*φ*₀ is 45°, *I*₁ is an incident light intensity of the first optical current transformer, *I*₂ is an incident light intensity of the second optical current transformer, *γ*₁ is a deflection angle of incident light of the first optical current transformer, and *γ*₂ is a deflection angle of incident light of the second optical current transformer.

Based on an apparatus for determining a current based on an optical current transformer, a target device corresponds to both a first optical current transformer and a second optical current transformer, and the target device operates on alternating current, where the first optical current transformer and the second optical current transformer are both configured to determine a real-time current value of the target device, a real-time current of the target device is directly proportional to an emergent light intensity of the first optical current transformer, the real-time current of the target device is directly proportional to an emergent light intensity of the second optical current transformer, the first optical current transformer corresponds to a first light intensity measurement range, and the second optical current transformer corresponds to a second light intensity measurement range, the second light intensity measurement range being greater than the first light intensity measurement range.

The apparatus includes:
a sampling unit, configured to: obtain, according to a preset sampling period, first emergent light intensity sampling values generated by the first optical current transformer, and obtain, according to the preset sampling period, second emergent light intensity sampling values generated by the second optical current transformer;
an identification unit, configured to identify whether each of the first emergent light intensity sampling values exceeds the first light intensity measurement range, and trigger a first determining unit if an identification result is negative;
the first determining unit, configured to determine a first final real-time current value of the target device at the same sampling time based on a first emergent light intensity sampling value and a second emergent light intensity sampling value at the same sampling time;
a generation unit, configured to generate a current waveform of the target device based on the first final real-time current value; and
an operation unit, configured to perform a relay protection operation based on the current waveform.

According to the foregoing apparatus, optionally, the apparatus further includes:
a setting unit, configured to use, if an identification result is that the second emergent light intensity sampling value exceeds the second light intensity measurement range, a last second emergent light intensity sampling value that does not exceed the second light intensity measurement range as a first final light intensity of the target device within a first time period; and
a second determining unit, configured to determine, based on the first final light intensity, a second final real-time current value of the target device within the first time period, where all second emergent light intensity sampling values within the first time period exceed the second light intensity measurement range, where
the generation unit is configured to generate a current waveform of the target device based on the second final real-time current value.

According to the foregoing apparatus, optionally, the apparatus further includes:
a third determining unit, configured to determine, if it is identified that the first emergent light intensity sampling value exceeds the first light intensity measurement range, a fourth final real-time current value of the target device based on the second emergent light intensity sampling value when it is determined that the second emergent light intensity sampling value falls within the second light intensity measurement range.

According to the foregoing apparatus, optionally, the first determining unit is specifically configured to:
determine a first current value based on the first emergent light intensity sampling value at the same sampling time;
determine a second current value based on the second emergent light intensity sampling value at the same sampling time; and
determine the first final real-time current of the target device at the same sampling time according to the following formula: first final real-time current = first current value * preset weight value + second current value * (1 - preset weight value).

According to the foregoing apparatus, optionally, the first optical current transformer corresponds to a first maximum light intensity measurement value and a first minimum light intensity measurement value, and the second optical current transformer corresponds to a second maximum light intensity measurement value and a second minimum light intensity measurement value, where the second maximum measurement value is greater than the first maximum measurement value, and the second minimum measurement value is less than the first minimum measurement value; $the first maximum measurement value = \frac{1}{{COS}^{2} {φ}_{0}} ∗ {I}_{1} ∗ {k}_{1 u} ;$ $the first minimum measurement value = \frac{1}{{COS}^{2} {φ}_{0}} ∗ {I}_{1} ∗ {k}_{1 d} ;$ $the second maximum measurement value = \frac{1}{{COS}^{2} {φ}_{0}} ∗ {I}_{2} ∗ {k}_{2 u} ;$ $the second minimum measurement value = \frac{1}{{COS}^{2} {φ}_{0}} ∗ {I}_{2} ∗ {k}_{2 d} ;$ ${k}_{1 u} = preset factor * \left(1-\frac{{γ}_{1}}{{φ}_{0}}\right) ;$ ${k}_{1 d} = \left(1-preset factor\right) * \left(1-\frac{{γ}_{1}}{{φ}_{0}}\right) ;$ ${k}_{2 u} = preset factor * \left(1-\frac{{γ}_{2}}{{φ}_{0}}\right) ;$ and ${k}_{2 d} = \left(1-preset factor\right) * \left(1-\frac{{γ}_{2}}{{φ}_{0}}\right) ,$ where
*φ*₀ is 45°, *I*₁ is an incident light intensity of the first optical current transformer, *I*₂ is an incident light intensity of the second optical current transformer, *γ*₁ is a deflection angle of incident light of the first optical current transformer, and *γ*₂ is a deflection angle of incident light of the second optical current transformer.

The present invention further provides an apparatus for determining a current based on an optical current transformer, including:
at least one memory, configured to store instructions; and
at least one processor, configured to perform, based on the instructions stored in the memory, the method for determining a current based on an optical current transformer according to any one of the foregoing embodiments.

The present invention further provides a readable storage medium, storing machine-readable instructions, where the machine-readable instructions, when executed by a machine, cause the machine to perform the method for determining a current based on an optical current transformer according to any one of the foregoing embodiments.

It can be seen from the foregoing solutions that, in the present invention, by determining the real-time current of the target device using two optical current transformers, measurement ranges of the optical current transformers can be extended, and measurement accuracy can be improved when the current is small.

### BRIEF DESCRIPTION OF THE DRAWINGS

Exemplary embodiments of the present invention are described in detail below with reference to the accompanying drawings, so that a person of ordinary skill in the art can understand the foregoing and other features and advantages of the present invention more clearly. In the accompanying drawings:
FIG. 1 is a schematic diagram of a current waveform determined based on an optical current transformer in the prior art.
FIG. 2 is a schematic flowchart of a method for determining a current based on an optical current transformer according to an embodiment of the present invention.
FIG. 3A is a schematic diagram of a current waveform corresponding to a method for determining a current based on an optical current transformer according to an embodiment of the present invention.
FIG. 3B is a schematic diagram of a current waveform corresponding to a method for determining a current based on an optical current transformer according to another embodiment of the present invention.
FIG. 4A is a schematic diagram of a current waveform in various states corresponding to a method for determining a current based on an optical current transformer according to an embodiment of the present invention.
FIG. 4B is a schematic diagram of a current waveform corresponding to an optical current transformer according to an embodiment of the present invention.
FIG. 5 is a schematic structural diagram of an apparatus for determining a current based on an optical current transformer according to an embodiment of the present invention.
FIG. 6A is a schematic structural diagram of an apparatus for determining a current based on an optical current transformer according to another embodiment of the present invention.
FIG. 6B is a schematic structural diagram of an apparatus for determining a current based on an optical current transformer according to still another embodiment of the present invention.

### DETAILED DESCRIPTION

To make the objective, technical solutions, and advantages of the present invention clearer, the present invention is further described in detail below using embodiments. In this patent application, nouns and pronouns referring to a person are not limited to any specific gender.

The inventor has found that when a deflection angle of incident light of an optical current transformer exceeds a certain angle, a current value measured by the optical current transformer may deviate.

Specifically, a formula obtained according to Malus' law may be expressed as:
*I* = *I*₀ · cos²*α*, where I is an emergent light intensity, *I*₀ represents an incident light intensity, and α represents a deflection angle of incident light. Generally, a deflection angle of incident light of an optical current transformer is within 45°.

According to the Faraday effect, *α*(*t*) *= B*(*t*) *· V · d.*

According to Ampere's circuital law, $B \left(t\right) = {μ}_{r} ⋅ {μ}_{0} ⋅ H \left(t\right) = {μ}_{r} ⋅ {μ}_{0} ⋅ \frac{i \left(t\right)}{2 πr}$.

Combining the foregoing two formulas yields $α \left(t\right) = {μ}_{r} ⋅ {μ}_{0} ⋅ \frac{i \left(t\right)}{2 πr} ⋅ d ⋅ V$.

Then, the following formula is obtained: $i \left(t\right) = α \left(t\right) . \frac{2 πr}{{μ}_{r} . {μ}_{0} . d} . \frac{1}{V}$ where *i*(*t*) represents a current of the device at time t, *α*(*t*) represents a deflection angle of incident light at time t, *µᵣ* represents a relative permeability of the optical current transformer, *µ*₀ represents a vacuum permeability of the optical current transformer, V represents a Verdet constant of the optical current transformer, *r* represents a radius of a closed magnetic field loop, and *d* indicates a length of light passing through a medium.

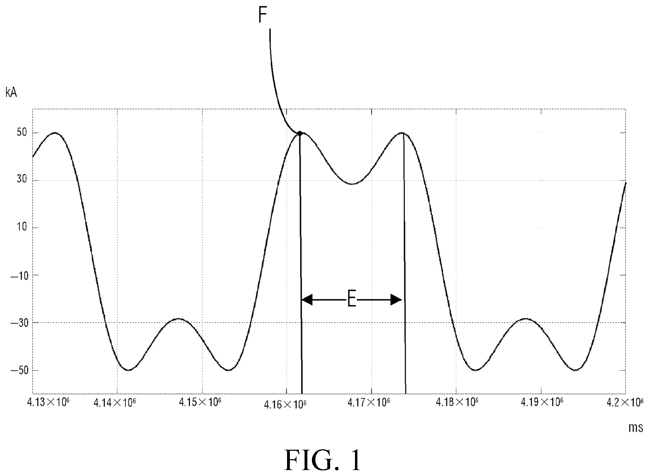

It can be seen from the foregoing formula that a larger deflection angle *α*(*t*) indicates a greater real-time current of the device. However, due to monotonicity of a cosine function, if the deflection angle of incident light changes from 45° to a negative value, and then increases from the negative value to 45°, a graph of a real-time current of the device obtained by the optical current transformer is shown in FIG. 1, where the horizontal axis represents time in millisecond (ms), and the vertical axis represents current in kA. It can be seen from FIG. 1 that a real-time current waveform of segment E is distorted. The real-time current waveform obtained based on the optical current transformer is sent to a relay protection apparatus, and the relay protection apparatus is highly likely to misoperate due to the distorted waveform.

Based on the foregoing reason, the present invention provides a method for determining a current based on an optical current transformer. The method is used to determine a real-time current of a target device. The target device may be any device requiring current measurement, for example, a switchgear, and the measured current is a primary-side current. The target device in the present invention corresponds to both a first optical current transformer and a second optical current transformer. The first optical current transformer and the second optical current transformer are both configured to determine a real-time current value of the target device, the real-time current of the target device is directly proportional to an emergent light intensity of the first optical current transformer, and the real-time current of the target device is directly proportional to an emergent light intensity of the second optical current transformer. The first optical current transformer corresponds to a first light intensity measurement range, and the second optical current transformer corresponds to a second light intensity measurement range, the second light intensity measurement range being greater than the first light intensity measurement range. The second light intensity measurement range being greater than the first light intensity measurement range indicates that a wavelength of incident light of the first optical current transformer is shorter than a wavelength of incident light of the second optical current transformer. The first light intensity measurement range represents a range less than or equal to a first maximum light intensity measurement value and greater than or equal to a first minimum light intensity measurement value, and the second light intensity measurement range represents a range less than or equal to a second maximum light intensity measurement value and greater than or equal to a second minimum light intensity measurement value. Accuracy of the second optical transformer is lower than that of the first optical current transformer. Especially when the real-time current of the target device is small, an error in a real-time current value obtained based on the second optical current transformer is large. Therefore, it is necessary to determine the real-time current value in combination with the first optical current transformer.

In the present invention, two optical current transformers are used as an example to process a measured real-time current of the target device, thereby avoiding erroneous triggering of the relay protection device. It should be noted that, in practical applications, the number of optical current transformers is not limited to two. For example, three, four, or even more optical current transformers may be used.

### Embodiment 1

This embodiment provides a method for determining a current based on an optical current transformer. The method is performed by an apparatus for determining a current based on an optical current transformer. The apparatus may be integrated into a relay protection apparatus or may be provided separately. Details are not described herein again. For a first optical current transformer and a second optical current transformer, wavelengths of their light sources may differ significantly. Such a combination is beneficial for measuring a wider range of real-time current while ensuring accuracy.

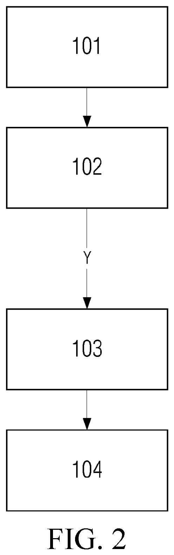

FIG. 2 is a schematic flowchart of a method for determining a current based on an optical current transformer according to this embodiment. The method includes the following steps.

Step 101: Obtain, according to a preset sampling period, first emergent light intensity sampling values generated by the first optical current transformer, and obtain, according to the preset sampling period, second emergent light intensity sampling values generated by the second optical current transformer.

The wavelength of the light source corresponding to the first optical current transformer is shorter than the wavelength of the light source corresponding to the second optical current transformer. The first optical current transformer senses a real-time current of a target device, and generates emergent light. The apparatus for determining a current performs sampling according to the preset sampling period, and a light intensity of the obtained emergent light is the first emergent light intensity sampling value. That is, an emergent light intensity of the first optical current transformer needs to be monitored in real time.

The second optical current transformer senses a real-time current of the target device, and generates emergent light. The apparatus for determining a current performs sampling on the second optical current transformer according to the preset sampling period, and a light intensity of the obtained emergent light is the second emergent light intensity sampling value. That is, an emergent light intensity of the second optical current transformer needs to be monitored in real time.

In this embodiment, the apparatus for determining a current based on an optical current transformer performs sampling on both the first optical current transformer and the second optical current transformer according to the same preset sampling period.

Step 102: Identify whether each of the first emergent light intensity sampling values exceeds a first light intensity measurement range, and if all identification results are positive, perform step 103.

In an exemplary description, the first emergent light intensity sampling value and the second emergent light intensity sampling value at a same time need to be monitored in real time. Whether the first emergent light intensity sampling value falls within the first light intensity measurement range may be determined based on the first emergent light intensity sampling value. If not, it indicates that the first emergent light intensity sampling value exceeds the first light intensity measurement range. Whether the second emergent light intensity sampling value falls within a second light intensity measurement range may further be determined based on the second emergent light intensity sampling value. Because the emergent light intensity sampling values are continuously acquired, whether each first emergent light intensity sampling value falls within the first light intensity measurement range and whether each second emergent light intensity sampling value falls within the second light intensity measurement range need to be continuously monitored. Certainly, when the second light intensity measurement range is greater than the first light intensity measurement range, it is also possible to identify whether the second emergent light intensity sampling value falls within the second light intensity measurement range after identifying that the first emergent light intensity sampling value exceeds the first light intensity measurement range. Specific selections may be made according to actual requirements, and details are not described herein again.

In this embodiment, the first light intensity measurement range may be determined based on characteristics of the first optical current transformer, and the second light intensity measurement range may also be determined based on characteristics of the second optical current transformer. It should be noted that the first light intensity measurement range is not a maximum light intensity or a minimum light intensity measurable by the first optical current transformer, but an inflection point at which a real-time current obtained based on the emergent light intensity of the first optical current transformer becomes inconsistent with a true current, for example, an inflection point F in FIG. 1. That is, a real-time current obtained based on an emergent light intensity within the first light intensity measurement range is consistent with the true current, and a real-time current obtained based on an emergent light intensity outside the first light intensity measurement range is inconsistent with the true current. Similarly, the second light intensity measurement range is not a maximum light intensity or a minimum light intensity measurable by the second optical current transformer, but an inflection point at which a real-time current obtained based on the emergent light intensity of the second optical current transformer becomes inconsistent with a true current. That is, a real-time current obtained based on an emergent light intensity within the second light intensity measurement range is consistent with the true current, and a real-time current obtained based on an emergent light intensity outside the second light intensity measurement range is inconsistent with the true current.

A measurement range of the second optical current transformer is greater than that of the first optical current transformer, but accuracy of the first optical current transformer is higher than that of the second optical current transformer.

Step 103: Determine, when a first emergent light intensity sampling value falls within the first light intensity measurement range, a first final real-time current of the target device at the same sampling time based on the first emergent light intensity sampling value and a second emergent light intensity sampling value at the same sampling time.

Specifically, a first current value may be determined based on the first emergent light intensity sampling value, a second current value may be determined based on the second emergent light intensity sampling value at the same time, and the first final real-time current at a target sampling time is determined based on a weight of the first current value and a weight of the second current value.

Certainly, other manners may be alternatively used to determine the first final real-time current at the target sampling time based on the first emergent light intensity sampling value and the second emergent light intensity sampling value. For example, the first emergent light intensity sampling value and the second emergent light intensity sampling value are weighted to obtain a new emergent light intensity sampling value, two incident light intensity sampling values are also weighted to obtain a new incident light intensity sampling value, and the first final real-time current at the target sampling time is obtained based on the new incident light intensity sampling value and the new emergent light intensity sampling value.

The accuracy of the first optical current transformer is higher than that of the second optical current transformer. Therefore, when away from the point F, a higher weight of the first emergent light intensity sampling value may be set, and when close to the point F, a lower weight of the first emergent light intensity sampling value may be set. This can avoid a discontinuity at the point F, thereby ensuring a smooth waveform and avoiding misoperation caused by the waveform discontinuity.

As a specific example, the step includes:
determining a first current value based on the first emergent light intensity sampling value at the same sampling time;
determining a second current value based on the second emergent light intensity sampling value at the same sampling time; and
determining the first final real-time current of the target device at the same sampling time according to the following formula: first final real-time current = first current value * preset weight value + second current value * (1 - preset weight value).

Specifically, the specific method for determining the current value of the target device based on the emergent light intensity sampling values belongs to the prior art, and details are not described herein again. The preset weight value may be set according to actual requirements. For example, the preset weight value q satisfies 0.7 ≤ q ≤ 0.9. Setting a higher weight of the first current value can improve accuracy of the first final real-time current.

In addition, the same sampling time indicates that in determining the first final real-time current, the emergent light intensity sampling values corresponding to the first current value and the second current value are obtained at the same sampling time. A case in which the first emergent light intensity sampling value falls within the first light intensity measurement range lasts for a period of time. During this period, a plurality of first final real-time current values are obtained, and a corresponding current waveform can be formed.

Step 104: Generate a current waveform of the target device based on the first final real-time current value, and perform a relay protection operation based on the current waveform.

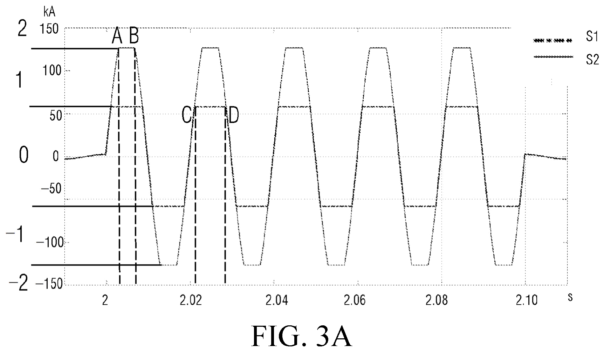

Specifically, the corresponding waveform may be formed based on all first final real-time current values. That is, when the emergent light intensity falls within the first light intensity measurement range, the method of this embodiment is used to obtain the first final real-time current value in the foregoing case, and generate the corresponding current waveform. For details, refer to a current waveform S2 in FIG. 3A. The relay protection apparatus performs a corresponding relay protection operation based on the current waveform. The specific method for performing a corresponding protection operation based on the current waveform belongs to the prior art, and details are not described herein again.

Optionally, the target device may further correspond to a plurality of optical current transformers, such as a third optical current transformer and a fourth optical current transformer, which correspond to different light intensity measurement ranges. For two optical current transformers corresponding to adjacent light intensity measurement ranges, the method of this embodiment may be used to obtain the final real-time current in the corresponding case. For example, if there is a third optical current transformer and a third light intensity measurement range corresponding to the third optical current transformer is greater than the second light intensity measurement range, when it is identified that the first emergent light intensity sampling value exceeds the first light intensity measurement range and the second emergent light intensity sampling value falls within the second light intensity measurement range, a real-time current value within the time period is determined based on the second emergent light intensity sampling value and a third emergent light intensity sampling value of the third optical current transformer at the same time, and a corresponding waveform is generated. This can avoid a discontinuity at an inflection point, and improve accuracy of the third optical current transformer. The same applies by analogy, and details are not described herein again.

According to this embodiment, by determining the real-time current of the target device using two optical current transformers, measurement ranges of the optical current transformers can be extended, and measurement accuracy can be improved when the current is small.

### Embodiment 2

This embodiment provides further supplementary description of the method for determining a current based on an optical current transformer in Embodiment 1. This embodiment mainly describes processing on a real-time current waveform obtained based on the first optical current transformer and a real-time current waveform obtained based on the second optical current transformer after sampling values exceed the first light intensity measurement range and the second light intensity measurement range, to avoid other misoperation caused by distortion.

In this embodiment, if an identification result is that the second emergent light intensity sampling value exceeds the second light intensity measurement range, a last second emergent light intensity sampling value that does not exceed the second light intensity measurement range is used as a first final light intensity of the target device within a first time period, and a second final real-time current of the target device within the first time period is determined based on the first final light intensity, where all second emergent light intensity sampling values within the first time period exceed the second light intensity measurement range.

A current waveform of the target device is generated based on the second final real-time current.

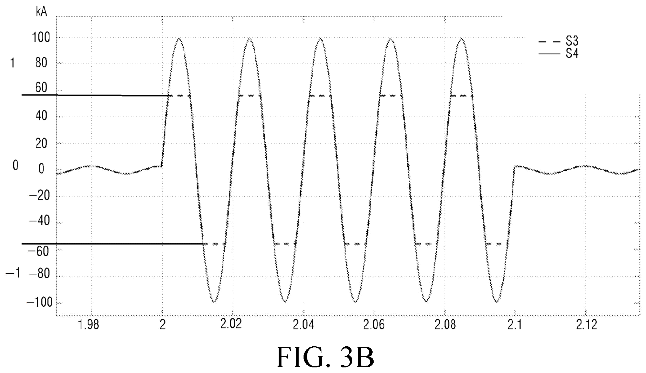

For example, as shown in FIG. 3A and FIG. 3B, the horizontal axis represents time in seconds (s), and the vertical axis represents current. Specifically, a column of numbers near the vertical axis indicates that the unit of current is kA. S2 in FIG. 3A refers to a current waveform obtained when the second emergent light intensity sampling value finally exceeds the second light intensity measurement range. S4 in FIG. 3B is a current waveform obtained when the first emergent light intensity sampling value exceeds the first light intensity measurement range and the second emergent light intensity sampling value remains within the second light intensity measurement range. As shown in FIG. 3A, a part between time A and time B represents the first time period in which the second emergent light intensity sampling value exceeds the second light intensity measurement range. A second light intensity sampling value at a sampling time preceding time A is used as a last second emergent light intensity sampling value that does not exceed the second light intensity measurement range, and a real-time current of the target device determined based on the second emergent light intensity sampling value is a second final real-time current value. Within the first time period between time A and time B, a current waveform is generated based on the second final real-time current value. That is, the current waveform within the first time period is processed as shown as segment AB of S2 in FIG. 3A, where time A is a start point of the first time period, and time B is an end point of the first time period. This avoids misoperation of the relay protection apparatus caused by the current waveform obtained based on the second real-time current.

Similarly, if the identification result is that the first emergent light intensity sampling value exceeds the first light intensity measurement range, a last first emergent light intensity sampling value that does not exceed the first light intensity measurement range is used as a second final light intensity of the target device within a second time period, and a third final real-time current of the target device within the second time period is determined based on the second final light intensity.

A current waveform of the target device is generated based on the third final real-time current.

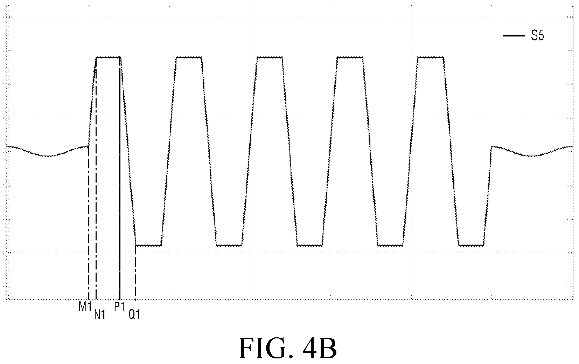

S1 in FIG. 3, S3 in FIG. 3B, and FIG. 4B are real-time current waveforms obtained based on the first optical current transformer. The current waveform within a second time period between time C and time D uses the third final real-time current. This avoids misoperation of the relay protection apparatus caused by the current waveform. The real-time current waveforms obtained based on the first optical current transformer indicated by S1 in FIG. 3 and S5 in FIG. 4B are current waveforms obtained by performing, when the first emergent light intensity sampling value exceeds the first light intensity measurement range, a correction on a real-time current corresponding to the part exceeding the measurement range. The correction refers to using a last first emergent light intensity sampling value that does not exceed the first light intensity measurement range as a second final light intensity of the target device within a second time period, and determining a third final real-time current of the target device within the second time period based on the second final light intensity.

Optionally, if it is identified that the first emergent light intensity sampling value falls within the first light intensity measurement range, a current waveform of the target device is generated based on the first emergent light intensity sampling value and the second emergent light intensity sampling value, and a relay protection operation is performed based on the current waveform.

That is, the current waveform S2 in FIG. 3A includes three parts. A case in which the emergent light intensity of the first optical current transformer falls within the first light intensity measurement range is considered as state 0, a case in which the emergent light intensity of the first current transformer is greater than or equal to a first maximum light intensity measurement value and the emergent light intensity of the second current transformer is less than or equal to a second maximum light intensity measurement value is considered as state 1, a case in which the emergent light intensity of the first current transformer is less than or equal to a first minimum light intensity measurement value and the emergent light intensity of the second current transformer is greater than or equal to a second minimum light intensity measurement value is considered as state -1, a case in which the emergent light intensity of the second current transformer is greater than the second maximum light intensity measurement value is considered as state 2, and a case in which the emergent light intensity of the second current transformer is less than the second minimum light intensity measurement value is considered as state -2, as indicated by a column of numbers on the left side of the vertical axis in FIG. 3A. When the first emergent light intensity sampling value falls within the first light intensity measurement range, a part corresponding to the current waveform S2 is determined based on the first emergent light intensity sampling value and the second emergent light intensity sampling value. When the first emergent light intensity sampling value exceeds the first light intensity measurement range and the second emergent light intensity sampling value falls within the second light intensity measurement range, the part corresponding to the current waveform S2 is obtained based on the second emergent light intensity sampling value. For example, a fourth final real-time current value of the target device within this period of time is determined based on the second emergent light intensity sampling value, and a corresponding waveform is determined. When the second emergent light intensity sampling value exceeds the second light intensity measurement range, the part corresponding to the current waveform S2 is obtained based on the second final real-time current value, the final current waveform is S2 in FIG. 3A, and the current protection apparatus performs a relay protection operation based on the current waveform.

The current waveform S4 in FIG. 3B includes two parts, and FIG. 3B does not include any case in state 2 or state -2. For the current waveform S4 in FIG. 3B, when the first emergent light intensity sampling value falls within the first light intensity measurement range, a part corresponding to the current waveform S4 is determined based on the first emergent light intensity sampling value and the second emergent light intensity sampling value. When the first emergent light intensity sampling value exceeds the first light intensity measurement range and the second emergent light intensity sampling value falls within the second light intensity measurement range, the part corresponding to the current waveform S4 is obtained based on the second emergent light intensity sampling value. For example, a fourth final real-time current value of the target device within this period of time is determined based on the second emergent light intensity sampling value, and a corresponding waveform is determined. A case in which the emergent light intensity of the first optical current transformer falls within the first light intensity measurement range is considered as state 0, a case in which the emergent light intensity of the first current transformer is greater than or equal to the first maximum light intensity measurement value and the emergent light intensity of the second current transformer is less than or equal to the second maximum light intensity measurement value is considered as state 1, and a case in which the emergent light intensity of the first current transformer is less than or equal to the first minimum light intensity measurement value and the emergent light intensity of the second current transformer is greater than or equal to the second minimum light intensity measurement value is considered as state -1, as indicated by a column of numbers away from the vertical axis in FIG. 3B.

In this way, when further operations need to be performed using the real-time current waveform based on the first optical current transformer alone or using the real-time current waveform based on the second optical current transformer alone, misoperation caused by the original distorted waveform can be avoided.

### Embodiment 3

This embodiment provides further supplementary description of the method for determining a current based on an optical current transformer in the foregoing embodiment.

In this embodiment, the first light intensity measurement range corresponds to a first maximum light intensity measurement value and a first minimum light intensity measurement value, and the second light intensity measurement range corresponds to a second maximum light intensity measurement value and a second minimum light intensity measurement value, where the second maximum measurement value is greater than the first maximum measurement value, and the second minimum measurement value is less than first minimum measurement value.

In this embodiment, $the first maximum measurement value = \frac{1}{{COS}^{2} {φ}_{0}} ∗ {I}_{1} ∗ {k}_{1 u}$; $the first minimum measurement value = \frac{1}{{COS}^{2} {φ}_{0}} ∗ {I}_{1} ∗ {k}_{1 d} ;$ $the second maximum measurement value = \frac{1}{{COS}^{2} {φ}_{0}} ∗ {I}_{2} ∗ {k}_{2 u} ;$ $the second minimum measurement value = \frac{1}{{COS}^{2} {φ}_{0}} ∗ {I}_{2} ∗ {k}_{2 d} ;$ ${k}_{1 u} = preset factor * \left(1-\frac{{γ}_{1}}{{φ}_{0}}\right) ;$ ${k}_{1 d} = \left(1-preset factor\right) * \left(1-\frac{{γ}_{1}}{{φ}_{0}}\right) ;$ ${k}_{2 u} = preset factor * \left(1-\frac{{γ}_{2}}{{φ}_{0}}\right) ;$ and ${k}_{2 d} = \left(1-preset factor\right) * \left(1-\frac{{γ}_{2}}{{φ}_{0}}\right) ,$ where
*φ*₀ is 45°, *I*₁ is an incident light intensity of the first optical current transformer, *I*₂ is an incident light intensity of the second optical current transformer, *γ*₁ is a deflection angle of incident light of the first optical current transformer, and *γ*₂ is a deflection angle of incident light of the second optical current transformer.

The preset factor may be set according to actual situations, for example, based on characteristics of the optical current transformer. The preset factor satisfies 0 < preset factor < I, and may be, for example, 0.9, and certainly may also be other values. Details are not described herein again.

As an example, a primary-side current of the target device is measured using both the first optical current transformer and the second optical current transformer. Real-time emergent light intensities of the first optical current transformer and the second optical current transformer are input into a relay protection apparatus, and the relay protection apparatus also learns in advance respective incident light intensities of the first optical current transformer and the second optical current transformer. More specifically, the relay protection apparatus includes two circuit boards. A first circuit board is configured to perform protection analysis on an input current waveform, to trigger a corresponding protective action. A second circuit board is configured to acquire light intensity information sent by the first optical current transformer and the second optical current transformer, and generate a corresponding current waveform to be input into the first circuit board. The current waveform generated by the second circuit board may also be obtained during other periods.

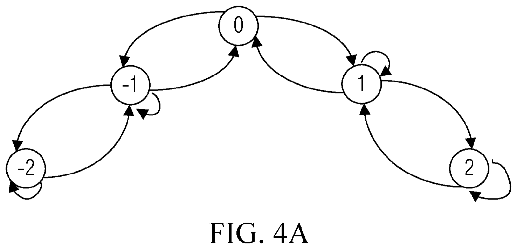

In this embodiment, the case in which the emergent light intensity of the first optical current transformer falls within the first light intensity measurement range is considered as state 0, the case in which the emergent light intensity of the first current transformer is greater than or equal to the first maximum light intensity measurement value and the emergent light intensity of the second current transformer is less than or equal to the second maximum light intensity measurement value is considered as state 1, the case in which the emergent light intensity of the first current transformer is less than or equal to the first minimum light intensity measurement value and the emergent light intensity of the second current transformer is greater than or equal to the second minimum light intensity measurement value is considered as state -1, the case in which the emergent light intensity of the second current transformer is greater than the second maximum light intensity measurement value is considered as state 2, and the case in which the emergent light intensity of the second current transformer is less than the second minimum light intensity measurement value is considered as state -2, as shown in FIG. 3A and FIG. 3B. FIG. 4A is a schematic diagram of transitions between states according to this embodiment. That is, the state transitions from state 0 to state 1, then from state 1 to state 2, and then returns from state 2 to state 1, and from state 1 to state 0. Similarly, the state transitions from state 0 to state -1, then from state -1 to state -2, and then returns from state -2 to state -1, and from state -1 to state 0.

The relay protection apparatus respectively continues to perform sampling on the emergent light intensity of the first optical current transformer and the emergent light intensity of the second optical current transformer according to the same sampling period, to obtain a first emergent light intensity sampling value and a second emergent light intensity sampling value at the same time.

FIG. 4B is a schematic diagram of a current waveform obtained when the first emergent light intensity sampling value exceeds the first light intensity measurement range, where S5 is a schematic diagram of a current waveform obtained based solely on the first optical current transformer. Specifically, if it is determined, based on the first emergent light intensity sampling value, that a current state is state 0, the current waveform S5 obtained based on the first emergent light intensity sampling value is as shown by a segment from M1 to N1 in FIG. 4B. If it is identified that the first emergent light intensity sampling value exceeds the first light intensity measurement range, a first final real-time current value of the target device at a target sampling time is determined based on a last first emergent light intensity sampling value that does not exceed the first light intensity measurement range, to obtain a segment from N1 to P1 of the current waveform S5 in FIG. 4B. If it is identified that the first emergent light intensity sampling value returns to the first light intensity measurement range, that is, returns to state 0, the current waveform S5 obtained based on the first emergent light intensity sampling value is as shown by a segment from P1 to Q1 in FIG. 4B. This process is repeated.

If the second emergent light intensity sampling value exceeds the second light intensity measurement range, a shape of a current waveform obtained based solely on the second optical current transformer is similar to that in FIG. 4B. In addition, as shown in FIG. 3A, the current waveform S2 is a schematic diagram of a current waveform output from the second circuit board to the first circuit board, and shows the current waveform corresponding to state 0, state 1, and state 2. The current waveform S2 is provided to the first circuit board for subsequent relay protection operations based on the current waveform.

### Embodiment 4

This embodiment provides an apparatus for determining a current based on an optical current transformer. The apparatus may be integrated into a relay protection apparatus or may be provided separately, or may be considered as a relay protection apparatus. Details are not described herein again. For a first optical current transformer and a second optical current transformer, wavelengths of their light sources may differ significantly. Such a combination is beneficial for measuring a wider range of real-time current while ensuring accuracy.

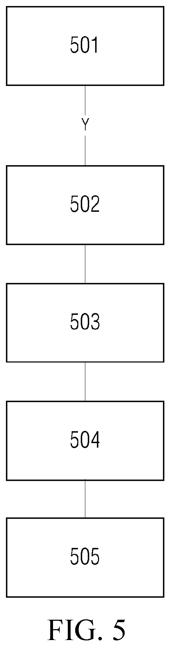

FIG. 5 is a schematic structural diagram of an apparatus for determining a current based on an optical current transformer according to this embodiment. The apparatus for determining a current based on an optical current transformer includes a sampling unit 501, an identification unit 502, a first determining unit 503, a generation unit 504, and an operation unit 505.

The sampling unit 501 is configured to: obtain, according to a preset sampling period, first emergent light intensity sampling values generated by the first optical current transformer, and obtain, according to the preset sampling period, second emergent light intensity sampling values generated by the second optical current transformer. The identification unit 502 is configured to identify whether each of the first emergent light intensity sampling values exceeds a first light intensity measurement range, and trigger the first determining unit 503 if an identification result is negative. The first determining unit 503 is configured to determine a first final real-time current value of a target device at the same sampling time based on a first emergent light intensity sampling value and a second emergent light intensity sampling value at the same sampling time. The generation unit 504 is configured to generate a current waveform of the target device based on the first final real-time current value. The operation unit 505 is configured to perform a relay protection operation based on the current waveform.

Optionally, the first determining unit 503 is specifically configured to:
determine a first current value based on the first emergent light intensity sampling value at the same sampling time;
determine a second current value based on the second emergent light intensity sampling value at the same sampling time; and
determine the first final real-time current of the target device at the same sampling time according to the following formula: first final real-time current = first current value * preset weight value + second current value * (1 - preset weight value).

Optionally, the preset weight value q satisfies 0.7 ≤ q ≤ 0.9.

Optionally, the first optical current transformer corresponds to a first maximum light intensity measurement value and a first minimum light intensity measurement value, and the second optical current transformer corresponds to a second maximum light intensity measurement value and a second minimum light intensity measurement value, where the second maximum measurement value is greater than the first maximum measurement value, and the second minimum measurement value is less than first minimum measurement value; $the first maximum measurement value = \frac{1}{{COS}^{2} {φ}_{0}} ∗ {I}_{1} ∗ {k}_{1 u} ;$ $the first minimum measurement value = \frac{1}{{COS}^{2} {φ}_{0}} ∗ {I}_{1} ∗ {k}_{1 d} ;$ $the second maximum measurement value = \frac{1}{{COS}^{2} {φ}_{0}} ∗ {I}_{2} ∗ {k}_{2 u} ;$ $the second minimum measurement value = \frac{1}{{COS}^{2} {φ}_{0}} ∗ {I}_{2} ∗ {k}_{2 d} ;$ ${k}_{1 u} = preset factor * \left(1-\frac{{γ}_{1}}{{φ}_{0}}\right) ;$ ${k}_{1 d} = \left(1-preset factor\right) * \left(1-\frac{{γ}_{1}}{{φ}_{0}}\right) ;$ ${k}_{2 u} = preset factor * \left(1-\frac{{γ}_{2}}{{φ}_{0}}\right) ;$ and ${k}_{2 d} = \left(1-preset factor\right) * \left(1-\frac{{γ}_{2}}{{φ}_{0}}\right) ,$ where
*φ*₀ is 45°, *I*₁ is an incident light intensity of the first optical current transformer, *I*₂ is an incident light intensity of the second optical current transformer, *γ*₁ is a deflection angle of incident light of the first optical current transformer, and *γ*₂ is a deflection angle of incident light of the second optical current transformer.

Operation methods of the units in this embodiment are the same as those in the foregoing embodiments, and details are not described herein again.

According to this embodiment, when it is determined, using two optical current transformers, that an emergent light intensity caused by the real-time current of the target device exceeds the first light intensity measurement range of the first optical current transformer and falls within the second light intensity measurement range of the second optical current transformer, the first emergent light intensity sampling value and the second emergent light intensity sampling value are combined to obtain the real-time current of the target device. The real-time current is closer to a true current of the target device, and a relay protection operation is performed based on the current waveform generated by the real-time current, thereby avoiding misoperation.

### Embodiment 5

This embodiment provides further supplementary description of the apparatus for determining a current based on an optical current transformer in Embodiment 4.

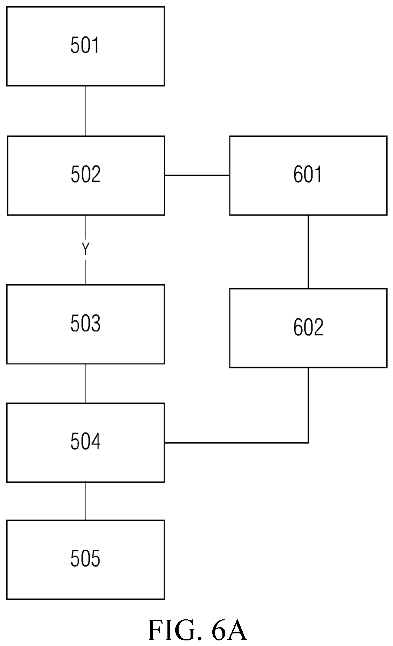

FIG. 6A is a schematic structural diagram of an apparatus for determining a current based on an optical current transformer according to this embodiment. In addition to the sampling unit 501, the identification unit 502, the first determining unit 503, the generation unit 504, and the operation unit 505 that are included in the foregoing embodiment, the apparatus for determining a current based on an optical current transformer in this embodiment further includes a setting unit 601 and a second determining unit 602.

The setting unit 601 is configured to use, if an identification result is that the second emergent light intensity sampling value exceeds the second light intensity measurement range, a last second emergent light intensity sampling value that does not exceed the second light intensity measurement range as a first final light intensity of the target device within a first time period. The second determining unit 602 is configured to determine, based on the first final light intensity, a second final real-time current value of the target device within the first time period, where all second emergent light intensity sampling values within the first time period exceed the second light intensity measurement range. Correspondingly, the generation unit 504 is configured to generate a current waveform of the target device based on the second final real-time current value.

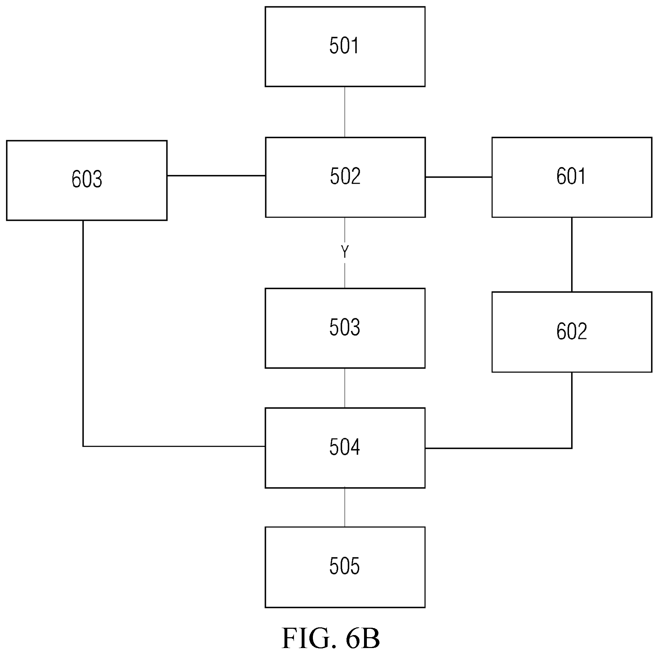

Optionally, as shown in FIG. 6B, the apparatus for determining a current based on an optical current transformer further includes a third determining unit 603. The third determining unit 603 is configured to determine, if it is identified that the first emergent light intensity sampling value exceeds the first light intensity measurement range, a fourth final real-time current value of the target device based on the second emergent light intensity sampling value when it is determined that second emergent light intensity sampling value falls within the second light intensity measurement range. The operation of identifying that the first emergent light intensity sampling value exceeds the first light intensity measurement range may be specifically performed by the identification unit 502, and the result may be notified to the third determining unit 603, or may be actively obtained by the third determining unit 603 from the identification unit 502. Correspondingly, the generation unit is configured to generate a current waveform of the target device based on the fourth final real-time current value.

Operation methods of the units in this embodiment are the same as those in the foregoing embodiments, and details are not described herein again.

This avoids misoperation of the relay protection apparatus caused by the current waveform obtained based on the second final real-time current.

The present invention further provides an apparatus for determining a current based on an optical current transformer, including at least one memory and at least one processor. The memory is configured to store instructions. The processor is configured to perform, based on the instructions stored in the memory, the method for determining a current based on an optical current transformer according to any one of the foregoing embodiments. The apparatus for determining a current based on an optical current transformer may be a relay protection apparatus.

The embodiments of the present invention further provide a readable storage medium. The readable storage medium stores machine-readable instructions, where the machine-readable instructions, when executed by a machine, cause the machine to perform the method for determining a current based on an optical current transformer according to any one of the foregoing embodiments.

The readable medium stores the machine-readable instructions, where the machine-readable instructions, when executed by a processor, cause the processor to perform any one of the foregoing methods. Specifically, a system or an apparatus provided with the readable storage medium may be provided. The readable storage medium stores software program code for implementing functions in any one of the foregoing embodiments, and a computer or processor of the system or the apparatus is enabled to read and execute the machine-readable instructions stored in the readable storage medium.

In this case, program code read from the readable medium can implement the functions in any one of the foregoing embodiments. Therefore, machine-readable code and the readable storage medium for storing the machine-readable code constitute a part of the present invention.

Embodiments of the readable storage medium include a floppy disk, a hard disk, a magneto-optical disk, an optical disc (such as CD-ROM, CD-R, CD-RW, DVD-ROM, DVD-RAM, DVD-RW, or DVD+RW), a magnetic tape, a non-volatile memory card, and a ROM. Optionally, the program code may be downloaded from a server computer or a cloud through a communication network.

A person skilled in the art should understand that various modifications and variations may be made to the embodiments disclosed above without departing from the essence of the present invention. Therefore, the protection scope of the present invention shall be defined by the appended claims.

It should be noted that not all steps and units in the foregoing processes and system structural diagrams are necessary, and some steps or units may be omitted according to actual requirements. The execution order of the steps is not fixed and may be adjusted as required. The apparatus structure described in the foregoing embodiments may be a physical structure or a logical structure. That is, some units may be implemented by the same physical entity, or some units may be implemented by a plurality of physical entities, or may be jointly implemented by some components in a plurality of independent devices.

In the foregoing embodiments, the hardware units may be implemented mechanically or electrically. For example, a hardware unit or processor may include a permanently dedicated circuit or logic (such as a dedicated processor, an FPGA, or an ASIC) to perform a corresponding operation. The hardware unit or processor may further include programmable logic or a circuit (such as a general-purpose processor or another programmable processor), which may be temporarily configured by software to perform a corresponding operation. A specific implementation (a mechanical manner, a dedicated permanent circuit, or a temporarily configured circuit) may be determined based on cost and time considerations.

The foregoing descriptions are merely exemplary embodiments of the present invention, but are not intended to limit the present invention. Any modifications, equivalent replacements, or improvements made within the spirit and principle of the present invention shall fall within the protection scope of the present invention.

## Claims

1. A method for determining a current based on an optical current transformer, wherein a target device corresponds to both a first optical current transformer and a second optical current transformer, and the target device operates on alternating current, wherein the first optical current transformer and the second optical current transformer are both configured to determine a real-time current value of the target device, a real-time current of the target device is directly proportional to an emergent light intensity of the first optical current transformer, the real-time current of the target device is directly proportional to an emergent light intensity of the second optical current transformer, the first optical current transformer corresponds to a first light intensity measurement range, and the second optical current transformer corresponds to a second light intensity measurement range, the second light intensity measurement range being greater than the first light intensity measurement range; and
the method comprises:
obtaining, according to a preset sampling period, first emergent light intensity sampling values generated by the first optical current transformer;
obtaining, according to the preset sampling period, second emergent light intensity sampling values generated by the second optical current transformer;
identifying whether each of the first emergent light intensity sampling values exceeds the first light intensity measurement range;
determining, when a first emergent light intensity sampling value falls within the first light intensity measurement range, a first final real-time current value of the target device at the same sampling time based on the first emergent light intensity sampling value and a second emergent light intensity sampling value at the same sampling time; and
generating a current waveform of the target device based on the first final real-time current value, and performing a relay protection operation based on the current waveform.

2. The method according to claim 1, further comprising:
using, if an identification result is that the second emergent light intensity sampling value exceeds the second light intensity measurement range, a last second emergent light intensity sampling value that does not exceed the second light intensity measurement range as a first final light intensity of the target device within a first time period, and determining, based on the first final light intensity, a second final real-time current value of the target device within the first time period, wherein all second emergent light intensity sampling values within the first time period exceed the second light intensity measurement range; and
generating a current waveform of the target device based on the second final real-time current value.

3. The method according to claim 1, further comprising:
determining, if it is identified that the first emergent light intensity sampling value exceeds the first light intensity measurement range, a fourth final real-time current value of the target device based on the second emergent light intensity sampling value when it is determined that the second emergent light intensity sampling value falls within the second light intensity measurement range.

4. The method according to claim 1, wherein determining a first final real-time current of the target device at the same sampling time based on the first emergent light intensity sampling value and the second emergent light intensity sampling value at the same sampling time comprises:
determining a first current value based on the first emergent light intensity sampling value at the same sampling time;
determining a second current value based on the second emergent light intensity sampling value at the same sampling time; and
determining the first final real-time current of the target device at the same sampling time according to the following formula: first final real-time current = first current value * preset weight value + second current value * (1 - preset weight value).

5. The method according to claim 4, wherein the preset weight value q satisfies 0.7 ≤ q ≤ 0.9.

6. The method according to any one of claims 1 to 5, wherein the first optical current transformer corresponds to a first maximum light intensity measurement value and a first minimum light intensity measurement value, and the second optical current transformer corresponds to a second maximum light intensity measurement value and a second minimum light intensity measurement value, wherein the second maximum measurement value is greater than the first maximum measurement value, and the second minimum measurement value is less than the first minimum measurement value; $the first maximum measurement value = \frac{1}{{COS}^{2} {φ}_{0}} ∗ {I}_{1} ∗ {k}_{1 u} ;$ $the first minimum measurement value = \frac{1}{{COS}^{2} {φ}_{0}} ∗ {I}_{1} ∗ {k}_{1 d} ;$ $the second maximum measurement value = \frac{1}{{COS}^{2} {φ}_{0}} ∗ {I}_{2} ∗ {k}_{2 u} ;$ $the second minimum measurement value = \frac{1}{{COS}^{2} {φ}_{0}} ∗ {I}_{2} ∗ {k}_{2 d} ;$ ${k}_{1 u} = preset factor * \left(1-\frac{{γ}_{1}}{{φ}_{0}}\right) ;$ ${k}_{1 d} = \left(1-preset factor\right) * \left(1-\frac{{γ}_{1}}{{φ}_{0}}\right) ;$ ${k}_{2 u} = preset factor * \left(1-\frac{{γ}_{2}}{{φ}_{0}}\right) ;$ and ${k}_{2 d} = \left(1-preset factor\right) * \left(1-\frac{{γ}_{2}}{{φ}_{0}}\right) ,$ wherein
*φ*₀ is 45°, *I*₁ is an incident light intensity of the first optical current transformer, *I*₂ is an incident light intensity of the second optical current transformer, *γ*₁ is a deflection angle of incident light of the first optical current transformer, and *γ*₂ is a deflection angle of incident light of the second optical current transformer.

7. An apparatus for determining a current based on an optical current transformer, wherein a target device corresponds to both a first optical current transformer and a second optical current transformer, and the target device operates on alternating current, wherein the first optical current transformer and the second optical current transformer are both configured to determine a real-time current value of the target device, a real-time current of the target device is directly proportional to an emergent light intensity of the first optical current transformer, the real-time current of the target device is directly proportional to an emergent light intensity of the second optical current transformer, the first optical current transformer corresponds to a first light intensity measurement range, and the second optical current transformer corresponds to a second light intensity measurement range, the second light intensity measurement range being greater than the first light intensity measurement range; and
the apparatus comprises:
a sampling unit, configured to: obtain, according to a preset sampling period, first emergent light intensity sampling values generated by the first optical current transformer, and obtain, according to the preset sampling period, second emergent light intensity sampling values generated by the second optical current transformer;
an identification unit, configured to identify whether each of the first emergent light intensity sampling values exceeds the first light intensity measurement range, and trigger a first determining unit if an identification result is negative;
the first determining unit, configured to determine a first final real-time current value of the target device at the same sampling time based on a first emergent light intensity sampling value and a second emergent light intensity sampling value at the same sampling time;
a generation unit, configured to generate a current waveform of the target device based on the first final real-time current value; and
an operation unit, configured to perform a relay protection operation based on the current waveform.

8. The apparatus according to claim 7, further comprising:
a setting unit, configured to use, if an identification result is that the second emergent light intensity sampling value exceeds the second light intensity measurement range, a last second emergent light intensity sampling value that does not exceed the second light intensity measurement range as a first final light intensity of the target device within a first time period; and
a second determining unit, configured to determine, based on the first final light intensity, a second final real-time current value of the target device within the first time period, where all second emergent light intensity sampling values within the first time period exceed the second light intensity measurement range, wherein
the generation unit is configured to generate a current waveform of the target device based on the second final real-time current value.

9. The apparatus according to claim 7, further comprising:
a third determining unit, configured to determine, if it is identified that the first emergent light intensity sampling value exceeds the first light intensity measurement range, a fourth final real-time current value of the target device based on the second emergent light intensity sampling value when it is determined that the second emergent light intensity sampling value falls within the second light intensity measurement range.

10. The apparatus according to claim 7, wherein the first determining unit is specifically configured to:
determine a first current value based on the first emergent light intensity sampling value at the same sampling time;
determine a second current value based on the second emergent light intensity sampling value at the same sampling time; and
determine the first final real-time current of the target device at the same sampling time according to the following formula: first final real-time current = first current value * preset weight value + second current value * (1 - preset weight value).

11. The apparatus according to any one of claims 7 to 10, wherein the first optical current transformer corresponds to a first maximum light intensity measurement value and a first minimum light intensity measurement value, and the second optical current transformer corresponds to a second maximum light intensity measurement value and a second minimum light intensity measurement value, wherein the second maximum measurement value is greater than the first maximum measurement value, and the second minimum measurement value is less than the first minimum measurement value; $the first maximum measurement value = \frac{1}{{COS}^{2} {φ}_{0}} ∗ {I}_{1} ∗ {k}_{1 u} ;$ $the first minimum measurement value = \frac{1}{{COS}^{2} {φ}_{0}} ∗ {I}_{1} ∗ {k}_{1 d} ;$ $the second maximum measurement value = \frac{1}{{COS}^{2} {φ}_{0}} ∗ {I}_{2} ∗ {k}_{2 u} ;$ $the second minimum measurement value = \frac{1}{{COS}^{2} {φ}_{0}} ∗ {I}_{2} ∗ {k}_{2 d} ;$ ${k}_{1 u} = preset factor * \left(1-\frac{{γ}_{1}}{{φ}_{0}}\right) ;$ ${k}_{1 d} = \left(1-preset factor\right) * \left(1-\frac{{γ}_{1}}{{φ}_{0}}\right) ;$ ${k}_{2 u} = preset factor * \left(1-\frac{{γ}_{2}}{{φ}_{0}}\right) ;$ and ${k}_{2 d} = \left(1-preset factor\right) * \left(1-\frac{{γ}_{2}}{{φ}_{0}}\right) ,$ wherein
*φ*₀ is 45°, *I*₁ is an incident light intensity of the first optical current transformer, *I*₂ is an incident light intensity of the second optical current transformer, *γ*₁ is a deflection angle of incident light of the first optical current transformer, and *γ*₂ is a deflection angle of incident light of the second optical current transformer.

12. An apparatus for determining a current based on an optical current transformer, comprising:
at least one memory, configured to store instructions; and
at least one processor, configured to perform, based on the instructions stored in the memory, the method for determining a current based on an optical current transformer according to any one of claims 1 to 6.

13. A readable storage medium, storing machine-readable instructions, wherein the machine-readable instructions, when executed by a machine, cause the machine to perform the method for determining a current based on an optical current transformer according to any one of claims 1 to 6.
